# EUROPEAN PATENT APPLICATION

(11) **EP 4 528 301 A1**
(43) Date of publication of application: **26.03.2025**
(21) Application number: 23275137.0
(22) Date of filing: 20.09.2023
(51) Int. Cl.: G01R 33/38

(54) **CRYOSTAT STRUCTURE AND COMBINATION OF GETTERS**

(71) Applicant: Siemens Healthcare Limited, Camberley, Surrey GU15 3YL (GB)
(72) Inventor: Chorley, Simon, Oxford, OX2 9BN (GB)
(74) Representative: Maier, Daniel Oliver

(57) **Abstract**

The invention relates to a cryostat structure (31) for a magnetic resonance device (11), comprising an outer vacuum chamber (42), a thermal shield (33,34), a main magnet (17), and a combination of getters (50), wherein the combination of getters (50) comprises a hydrogen getter and a water getter. The invention further relates to a combination of getters (50) for use in an inventive cryostat structure (31) and a magnetic resonance device (11) comprising an inventive cryostat structure (31).

## Description

Independent of the grammatical term usage, individuals with male, female or other gender identities are included within the term.

Cryostats for conventional or "wet" magnetic resonance devices typically contain a volume of hundreds or thousands of litres of liquid cryogen which can evaporate during transport to maintain cryogenic temperatures within the cryostat. At such low temperatures, outgassing of construction materials of the cryostat is negligible and cold surfaces cryopump (i. e. retain) residual gases, thus maintaining a vacuum quality in the vacuum region. "Wet" magnetic resonance devices are typically heavier than "dry" magnetic resonance devices and comprise an increased heat capacity. Thus, "wet" magnetic resonance devices tend to warm up more slowly than "dry" magnetic resonance devices when disconnected from a cold source. Furthermore, cryostats in "wet" magnetic resonance devices comprise fewer vacuum-incompatible materials (e. g. materials that strongly outgas in a vacuum) which can significantly accelerate a deterioration of the vacuum quality.

Residual gases within the vacuum region can originate from several sources, for example:
- residual gas left after pumping the vacuum region (e. g. by not pumping for long enough),
- leakage through materials, (e. g. via micro leaks, grains and/or defects in materials or welds),
- leakage and/or permeation through seals, (e. g. polymer seals, O-rings, current feed-through pins, or a pump-out port seal),
- virtual leaks (e. g. unvented blind holes in a magnet structure or porous surfaces),
- outgassing from surfaces (e. g. by using vacuum incompatible materials or materials not optimized for vacuum applications), and/or
- chemical reactions inside the cryostat (e. g. curing of a resin of the magnet structure).

"Dry" magnetic resonance devices are generally lighter and do not comprise a significant volume of cryogen. Thus, "dry" magnetic resonance devices tend to warm up more quickly. Furthermore, in "dry" magnetic resonance devices, the entire magnet structure is arranged within the vacuum region. The magnet structure can outgas significantly, thus increasing an amount of residual gas in the vacuum region and accelerating heat transport mechanisms such as heat conduction and heat convection between a magnet and an outer vacuum chamber of the cryostat. With increasing temperatures inside the vacuum region, outgassing and chemical reactions releasing gas may be further accelerated. "Dry" magnetic resonance devices may favourably remain in transit for extended periods of time because they do not comprise significant volumes of expensive cryogen, which can be lost. However, due to the mechanisms explained above, the vacuum quality within the cryostat may deteriorate substantially in comparison to "wet" magnetic resonance devices.

As "dry" magnetic resonance devices arriving on site are typically re-cooled using only an integrated cryocooler, any residual gas within the vacuum region can become a significant problem. The process of cooling the cryostat usually takes a few days or weeks and a high amount of residual gas may extend the required time substantially. In some cases, the integrated cryocooler is not able to overcome the accelerated heat transport associated with residual gas within the vacuum region and fails to cool down the magnet structure to the cryogenic temperature. In this situation a service engineer is required on site to re-establish the vacuum, which leads to further delays and costs and can be particularly problematic in parts of the world without trained service engineers or access to required equipment.

It is an objective of the invention to reduce a degradation of a vacuum quality in a vacuum region of a magnetic resonance device, particularly a "dry" magnetic resonance device, disconnected from a cold source.

This objective is achieved by a cryostat structure and a combination of getters according to the invention. Further advantageous embodiments are specified in the dependent claims.

The inventive cryostat structure is configured to be used in a magnetic resonance device. The inventive cryostat structure comprises an outer vacuum chamber, a thermal shield, a main magnet, and a combination of getters.

The outer vacuum chamber may form a vessel which is substantially impermeable to fluids such as liquid or gaseous cryogens. The outer vacuum chamber may be configured to maintain a vacuum in an inner volume or vacuum region enclosed by the outer vacuum chamber. Preferably, the outer vacuum chamber encompasses cryogenically cooled components of a magnetic resonance device. For example, the outer vacuum chamber encompasses a cryogen vessel, the thermal shield, a further thermal shield, and the main magnet.

According to an embodiment, the outer vacuum chamber comprises an outer wall, an inner wall and annular end walls connecting the outer wall and the inner wall. The outer vacuum chamber may form a double-walled hollow cylinder configured to enclose the main magnet and the thermal shield between the outer wall, the inner wall, and the annular end walls. A cylinder axis of the outer vacuum chamber may be oriented in parallel to or correspond to an axis of rotational symmetry defined by a solenoidal coil of the main magnet. The inner wall of the outer vacuum chamber may correspond to a patient bore of a magnetic resonance device.

The main magnet may comprise or consist of one or more electromagnets or superconducting magnets. Particularly, the main magnet may comprise or consist of one or more solenoidal or cylindrical superconducting magnets or superconducting coils. The main magnet may comprise a support structure configured to carry the main magnet and/or to provide support to the main magnet. Thus, the term main magnet as used herein may comprise one or more solenoidal superconducting coils, but also the support structure.

The thermal shield may be configured to reduce a transport of heat energy to cryogenically cooled components within the cryostat structure, such as the main magnet and/or parts of the support structure. A transport of heat energy may be characterized by a heat transport mechanism such as thermal radiation, heat conduction, but also heat convection. The thermal shield may be configured to circumferentially encompass the main magnet. For example, the thermal shield may form a vessel configured to enclose the main magnet. In a preferred embodiment, the thermal shield comprises an outer wall, an inner wall and annular end walls connecting the outer wall and the inner wall. Particularly, the thermal shield may form a double-walled hollow cylinder configured to enclose the main magnet between the outer wall, the inner wall, and the annular end walls. A cylinder axis of the thermal shield may be oriented in parallel to or correspond an axis of rotational symmetry defined by a solenoidal coil of the main magnet.

Preferably, the thermal shield comprises or consists of a material with a high electrical conductivity and/or a high thermal conductivity. For example, the thermal shield may consist of copper or aluminium, particularly a copper alloy or an aluminium alloy. The thermal shield may also comprise gold, platinum, silver, or other materials with a high thermal conductivity. In one embodiment, the thermal shield is coated or galvanized with gold, platinum, or other metals with high thermal conductivity.

A getter may be characterized by a deposit of material, particularly a reactive material, configured to establish and/or maintain a vacuum in a vacuum region. For example, the getter may be configured adsorb a specific gas or a group of gasses via chemisorption and/or physisorption. It is also conceivable that the getter is configured to absorb a specific gas or a group of gasses and/or remove the specific gas, or the group of gasses from a volume, such as a vacuum region encompassed by the cryostat structure. The getter may also be configured to react with the specific gas or group of gasses to remove the specific gas or group of gasses from the volume. A getter may represent a flashed getter or a non-evaporable getter according to an embodiment described below.

A combination of getters may comprise or consist of a plurality of getters, particularly a plurality of different getter materials. Preferably, the combination of getters consists of a plurality of getters configured to remove different gases or different groups of gasses from a gas phase within the vacuum region. Particularly, the combination of getters may comprise two or more getters configured to remove two or more specific residual gases from the vacuum region enclosed by the outer vacuum chamber. A removal of a gas from the vacuum region via the combination of getters may comprise a liquification, a solidification, a deposition, an adsorption, an absorption, a chemisorption, and/or a chemical transformation of the gas. Particularly, removing a gas from the vacuum region via the combination of getters may comprise changing a physical state of the gas from a gaseous state to a liquid state or a solid state.

According to the invention, the combination of getters comprises a hydrogen getter and a water getter.

The hydrogen getter may be configured to remove hydrogen from the vacuum region enclosed by the outer vacuum chamber. Likewise, the water getter may be configured to remove gaseous water from the vacuum region enclosed by the outer vacuum chamber.

According to an embodiment, the outer vacuum chamber may comprise or consist of stainless steel. The hydrogen getter may be configured to absorb hydrogen released from stainless steel components of the outer vacuum chamber, but also hydrogen released by chemical processes within the outer vacuum chamber.

According to an embodiment, the hydrogen getter comprises a gas capacity of 12000 PaL to 150000 PaL. The hydrogen getter may be configured to maintain a vacuum quality in a cryostat structure encompassing a volume of approximately 3 m³.

In a preferred embodiment of the inventive cryostat structure, the hydrogen getter consists of a non-evaporable getter, particularly a non-evaporable, non-activated getter.

For example, the hydrogen getter may consist of a zeolite or an ion-exchanged zeolite, preferably a silver-exchanged zeolite. Zeolites may represent microporous, crystalline aluminosilicate materials. It is conceivable, that zeolites act as adsorbents. However, hydrogen may also adhere to a surface of the hydrogen getter via chemisorption. Ion-exchanged zeolites may be obtained via an ion-exchange procedure.

According to an embodiment, the hydrogen getter comprises a metal oxide. For example, the hydrogen getter may comprise copper oxide and/or manganese oxide. The metal oxide may be used in conjunction with an appropriate catalyst. For example, the metal oxide may be configured to remove hydrogen from the vacuum region in a catalytic reaction releasing water in accordance with equations (1), (2).

CuO + H2 → Cu + H2O (1)

MnO + H2 → Mn + H2O (2)

The hydrogen getter may comprise or consist of a plurality of getter materials, particularly a plurality of different getter materials.

In one embodiment, the hydrogen getter may comprise or consist of a non-evaporable, activated getter. For example, the hydrogen getter may consist of a metal alloy, preferably a zirconium alloy, a titanium alloy, or a palladium alloy. Preferably, the metal alloy comprises zirconium and at least one other metal, such as vanadium, cobalt, iron, aluminium, or the like. Preferably, the metal alloy comprises or forms a passivation layer at room temperature which disappears when the hydrogen getter is heated. The cryostat structure may comprise a heating device or heating mechanism configured for heating the hydrogen getter and remove the passivation layer to activate the hydrogen getter.

A hydrogen getter may favourably compensate for an outgassing of hydrogen from stainless steel components of the cryostat structure. In providing a hydrogen getter comprising or consisting of an ion-exchanged zeolite, particularly a silver-exchanged zeolite, a hydrogen selectivity of the hydrogen getter may favourably be increased. Furthermore, in providing a non-evaporable, non-activated hydrogen getter, a heating device or heating mechanism for activating the hydrogen getter may favourably be omitted.

The water getter may be configured to remove moisture and/or gaseous water from the vacuum region. Moisture may not be a problem for cool-down as it rapidly cryopumps or adheres onto cold surfaces of the cryostat structure when a cryocooler is engaged. However, particularly at ambient temperatures, moisture or gaseous water may accelerate heat transport mechanisms, so it is advantageous to remove it.

In removing gaseous water from the vacuum region, a heat transport based on heat conduction and/or heat convection may be favourably prevented or reduced. At the same time, a load on a vacuum pump connected to the vacuum region may favourably be decreased. Thus, the water getter may favourably decelerate heat transport mechanisms within the cryostat structure, and consequently, temperature dependent outgassing mechanisms within the cryostat structure.

Furthermore, some chemical processes within the vacuum region may depend on a presence of water and produce hydrogen to a great enough extent to overwhelm the hydrogen getter. For example, water may react with aluminium in the cryostat structure according to the equation (3):

2Al + 6H₂O → 2Al(OH)₃ + 3H₂ (3)

Beyond the example provided in equation (3), other chemical processes dependent on water as a reactant can take place. In reducing an amount of gaseous water in the vacuum region, chemical reactions releasing hydrogen may favourably be reduced. Thus, the gas capacity of the hydrogen getter may be reduced as well. Particularly, a required mass of the hydrogen getter may favourably be replaced by a less-expensive water getter. Thus, costs associated with the inventive cryostat structure may favourably be reduced.

Furthermore, the water getter may favourably prevent an air getter according to an embodiment described below from being exposed to water and release hydrogen as a result. The water getter may also prevent pores of a non-evaporable, non-activated hydrogen getter (e. g. a zeolite hydrogen getter) from getting blocked by water.

Water contained in components of the cryostat structure which outgas significantly in vacuum, such as thermal insulations (e. g. multi-layer insulations), but also polymers, resins and/or composites, can be a particular problem in "dry" magnetic resonance devices. Thus, the provision of a water getter may favourably decelerate the deterioration of the vacuum quality in the vacuum region.

In a preferred embodiment of the inventive cryostat structure, the water getter consists of a non-evaporable getter.

Particularly, the water getter may consist of a non-evaporable, non-activated getter. For example, the water getter may comprise or consist of a zeolite, a molecular sieve, a desiccant (e. g. calcium oxide), or any other suitable material which removes gaseous water in a vacuum. According to an embodiment, the water getter comprises calcium oxide which removes water, but also carbon dioxide, from the vacuum region according to equations (4) and (5).

CaO + H₂O = Ca(OH)₂ (4)

CaO + CO₂ = CaCO₃ (5)

Preferably, the water getter comprises a water capacity of 10 to 130 g at 75 % relative humidity and 25 °C.

According to an embodiment of the inventive cryostat structure, the water getter consists of a zeolite, a molecular sieve, or a desiccant, and the hydrogen getter consists of a zeolite, particularly a silver-exchanged zeolite.

In a preferred embodiment, the hydrogen getter and the water getter each consist of a non-evaporable, non-activated getter according to an embodiment described above.

In providing a non-activated getter, an effort and/or a cost associated with providing an activation mechanism and a dedicated electrical feed-through or signal connection may favourably be avoided. Furthermore, non-evaporable, non-activated getters according to an embodiment described above may withstand exposure to air for a prolonged period of time, for example several minutes to several hours. Thus, non-evaporable, non-activated getters may favourably be installed before a vacuum is established within the vacuum region, which may facilitate a manufacture of the cryostat structure.

An inventive cryostat structure may favourably decrease costs associated with the manufacture of a magnetic resonance device.

Furthermore, an inventive cryostat structure comprising a combination of getters according to an embodiment described above may favourably decelerate a degradation of a vacuum in a vacuum region enclosed by the outer vacuum chamber.

As a further advantage, the combination of getters of the inventive cryostat structure may favourably allow for re-cooling of the cryostat structure on site without requiring a re-establishment of the vacuum after transport or storage for up to 90 days or more. Thus, activities related to pumping and/or re-cooling may be abbreviated or avoided, and time may be saved. A magnetic resonance device comprising an inventive cryostat structure may also arrive colder after shipping in comparison to conventional magnetic resonance devices.

Furthermore, costs associated with putting a magnetic resonance device into operation after shipping may favourably be reduced, since dedicated equipment for re-establishing the vacuum in the vacuum region may be omitted. Thus, the inventive cryostat structure may favourably be installed on site by technicians with less training. As a further advantage, costs associated with the combination of getters may be significantly less than the costs incurred by pumping the vacuum on site.

The combination of getters may favourably decrease a deterioration of the vacuum within the vacuum region and allow for slower and less-expensive transportation methods, such as shipping by sea. Thus, greenhouse gas emissions associated with the transport of a magnetic resonance device may favourably be reduced.

A conventional hydrogen getter may be incapable of maintaining the quality of the vacuum within a cryostat structure of a "dry" magnetic resonance device. The inventive combination of getters may favourably maintain a desired vacuum quality of a "dry" magnetic resonance device over prolonged periods of time.

According to an embodiment of the inventive cryostat structure, at least one getter of the combination of getters is arranged between the outer vacuum chamber and the thermal shield.

For example, the hydrogen getter and the water getter, but also an air getter according to an embodiment described below, may be arranged between the outer vacuum chamber and the thermal shield. Preferably, the at least one getter is arranged between the wall of the outer vacuum chamber and a thermal insulation, particularly a multi-layer insulation, covering a surface of the thermal shield. The wall of the outer vacuum chamber may correspond to the outer wall of the outer vacuum chamber.

In an alternative embodiment of the inventive cryostat structure, at least one getter of the combination of getters is arranged in a region enclosed by the thermal shield.

A getter arranged between the outer vacuum chamber and the thermal shield may favourably be kept at a temperature close to an ambient temperature. Based on the Arrhenius or van 't Hoff equation, an effectiveness of a getter may be increased significantly when the getter is maintained at moderate temperatures in comparison to a cryogenic temperature or an intermediate temperature in a region enclosed by the thermal shield. Thus, a reduced amount of getter material may be required to remove a residual gas from the vacuum region.

According to an embodiment of the inventive cryostat structure, the combination of getters comprises an air getter.

An air getter may be configured to remove air or components of the air from a space and/or a vacuum region encompassed by the outer vacuum chamber.

Preferably, the air getter is configured to absorb residual air or components of the air left in the vacuum region after a vacuum has been established. For example, the air getter may be configured to absorb air which has permeated through sealings, but also air from leaks or virtual leaks in the cryostat structure.

The air getter may represent a flashed getter or a non-evaporable getter. Particularly, the air getter may comprise an activated or a non-activated getter material. A gas capacity of the air getter may depend on parameters of the magnetic resonance device governing a rate at which a component of the air is released or intrudes into the vacuum region. For a cryostat structure having a volume of approximately 3 m³, a gas capacity of 6000 PaL to 130000 PaL may be sufficient to allow transportation and warm storage for over 90 days.

According to an embodiment of the inventive cryostat structure, the air getter consists of a non-evaporable getter, particularly a non-evaporable, non-activated getter.

For example, the air getter may comprise or consist of a zeolite, particularly a Linde type A (LTA) zeolite or zeolite-based membrane. Zeolites may represent non-evaporable, non-activated getters.

It is also conceivable that the air getter is a non-evaporable getter, such as barium or another alkali or alkaline earth metal. An air getter comprising or consisting of an alkali metal or alkaline earth metal may represent a pre-evaporated getter. In some embodiments, an air getter comprising or consisting of an alkali metal or alkaline earth metal may require an activation, particularly a thermal activation.

In a further example, the air getter comprises a barium-lithium alloy, particularly a barium-lithium alloy in a 1:4 atomic ratio. The barium-lithium alloy may be configured to remove a plurality of gasses from the vacuum region. For example, the barium-lithium alloy may be configured to remove nitrogen and oxygen according to the equations (4) and (5).

3BaLi₄ + 3N₂ → Ba₃N₂ + 4Li₃N (4)

2BaLi₄ + 3O₂ → 2BaO + 4Li₂O (5)

According to an embodiment, the air getter comprises a plurality of different getters or different getter materials configured to remove different components of the air from the vacuum region.

In providing a combination of getters comprising an air getter, a hydrogen getter, and a water getter, a deterioration of a vacuum quality of a vacuum region enclosed by the cryostat structure may favourably be decelerated in comparison to a combination of getters comprising just a hydrogen getter and a water getter. Furthermore, the water getter may favourably prevent the air getter from being exposed to water and release hydrogen as a result. Thus, the combination of getters may provide a particularly efficient means for maintaining the vacuum quality.

According to a further embodiment of the inventive cryostat structure, the air getter consists of a flashed getter.

The air getter may be based on a volatile metal, such as barium or lithium. However, other materials are conceivable. A flashed air getter may comprise an activation mechanism according to an embodiment described above.

In providing a flashed getter, a surface area of the reactive getter material may favourably be increased in comparison to other getter materials.

According to an embodiment, the inventive cryostat structure comprises a pump-out port and a plug configured to provide a fluid-tight seal on the pump-out port.

The pump-out port may represent a connector, or a connecting piece configured to connect to a vacuum pump and/or a conduit connected to a vacuum pump. The plug may represent a lid, a cap, or a cover configured to provide a fluid-tight seal on the pump-out port. Particularly, the plug may be configured to provide a vacuum-tight seal on the pump-out port.

According to the invention, the air getter is mounted to a side of the plug facing towards an inner volume of the cryostat structure.

Preferably, the air getter is contained in a gas-permeable bag or casing. The bag or casing containing the air getter may be mounted to the plug via any suitable mechanical connection. For example, the bag or casing containing the air getter may be attached to the plug via an adhesive. However, the bag or casing containing the air getter may also be clamped or strapped to the plug. In a preferred embodiment, the plug comprises a recess or a sleeve configured to accommodate the air getter. For example, the recess or sleeve comprises a gas-permeable cover, such as a lattice or mesh, configured to secure the air getter within the recess or sleeve. However, other means of securing the air getter to the plug are conceivable.

In mounting the air getter on the plug of the pump-out port, the air getter may favourably be arranged within the cryostat structure after a vacuum is established and the pump-out port is sealed via the plug.

According to an embodiment of the inventive cryostat structure, the water getter and/or the hydrogen getter comprise a loose material, or a loose material enclosed in a gas-permeable casing.

Preferably, the water getter and/or the hydrogen getter consist of a non-evaporable, non-activated getter material according to an embodiment described above. A loose material may be characterized by an absence of any packaging or wrapping. The water getter and/or the hydrogen getter may be present in a particulate form. For example, the loose material may comprise or consist of disjointed pellets, beads, pebbles, and/or particles.

In providing the water getter and/or the hydrogen getter in the form of a loose material, an active surface of the water getter and/or the hydrogen getter may favourably be increased. Thus, an efficiency of the getter material may be increased in comparison to getters enclosed in a casing.

In a preferred embodiment, the loose material of the water getter and the hydrogen getter is disposed freely moveable within a volume encompassed by the outer vacuum chamber.

Small-grained or particulate getter materials may not be able to damage components of the cryostat structure, even if the getter material moves within the cryostat structure during a transport of the cryogen structure. Thus, a provision of means for securing the getter material inside the cryostat structure may favourably be omitted.

Furthermore, a small-grained, loose material may be introduced into the vacuum region via a particularly small opening in an outer shell or wall of the cryostat structure, such as a cable feed-through. Thus, an extra port configured to accommodate larger aggregations of getter material my favourably be avoided.

According to an embodiment, the water getter and/or the hydrogen getter comprise a loose material enclosed in a gas-permeable casing or bag. For example, one or more bags containing the loose material may be disposed freely moveable within the cryostat structure. In providing a bag or a casing containing the loose material of the water getter and/or the hydrogen getter, a handling of the getter material may favourably be facilitated.

According to an embodiment of the inventive cryostat structure, the hydrogen getter consists of a flashed getter.

A material of a flashed getter may require an activation, particularly a heat activation, before being able to remove a gas from the vacuum region. Particularly, a flashed getter may need to be activated by evaporation. For example, the flashed getter may comprise a reactive, volatile material, such as barium, lithium, phosphorus, or the like. The vaporized getter material may be configured to react with residual hydrogen gas within the vacuum region and condense on a wall of the outer vacuum chamber or a cold surface within the outer vacuum chamber. The condensed getter material may produce a thin coating on the wall or the cold surface within the outer vacuum chamber. The thin coating may favourably be configured to continue to remove hydrogen, but also other gasses, from the vacuum region.

According to a preferred embodiment, the cryostat structure comprises a heating mechanism, particularly an inductive heating device, configured to activate the flashed getter once a vacuum has been established within the vacuum region.

The inventive combination of getters is configured for use in a cryostat structure.

The combination of getters may be configured to remove a specific group or combination of gasses or gas components from a vacuum region of a cryostat structure of a magnetic resonance device. Particularly, the combination of getters may be configured to remove typical residual gasses, such as water, hydrogen, but also air components, from the vacuum region of the cryostat structure.

In a preferred embodiment, the combination of getters is configured to remove at least water and hydrogen from a vacuum region enclosed by the cryostat structure. Additionally, the combination of getters may be configured to remove at least one of the following gasses from the vacuum region: nitrogen, oxygen, carbon dioxide. The combination of getters may be configured to remove at least two or at least three of the mentioned gasses from the vacuum region enclosed by the cryostat structure.

According to the invention, the combination of getters comprises a water getter and a hydrogen getter.

As described above, the water getter may be configured to reduce an amount of gaseous water in the vacuum region, but also inhibit chemical reactions releasing hydrogen. Thus, the water getter may favourably replace a required amount of the hydrogen getter.

In a preferred embodiment, the inventive combination of getters comprises or consists of non-evaporable, non-activated getters according to an embodiment described above. Particularly, the combination of getters may comprise or consist of a zeolite, a desiccant, and/or a molecular sieve according to an embodiment described above.

The combination of getters may contain a mixture or composition of getter materials. For example, the combination of getters may comprise two or more getter materials, preferably mixed as loose materials. Thus, the combination of getters may comprise a mixture of loose materials. However, at least one getter of the combination of getters may be enclosed in a gas-permeable bag or casing.

According to an embodiment, the combination of getters comprises a kit-of-parts. The combination of getters may comprise or consist of two or more separate getters. For example, the two more getters may be enclosed in separate bags or casings. The two or more getters may be configured to be introduced into the vacuum region separately or in a mixed-up form. The two or more getters may at least comprise a hydrogen getter and a water getter.

In providing an inventive combination of getters, chemical reactions using water as an educt to generate or release hydrogen may favourably be inhibited by removing water from the vacuum region via the water getter. Thus, a required gas capacity of the hydrogen getter can favourably be reduced. The inventive combination of getters may be particularly relevant for applications where the combination of getters is held at a temperature level close to an ambient temperature. At vacuum conditions and ambient temperature, water is usually present in a gaseous state and may contribute significantly to reactions releasing hydrogen.

According to an embodiment, the combination of getters further comprises an air getter.

The air getter may correspond to an embodiment of an air getter described above. For example, the air getter may comprise or consist of a flashed getter, a non-evaporable getter, but also a non-activated getter.

In a preferred embodiment, the combination of getters consists of non-evaporable, non-activated getters.

The inventive combination of getters may favourably be tuned to remove specific residual gasses, such as gaseous water, hydrogen, but also air components, from the vacuum region of a magnetic resonance device.

Particularly, a weight ratio or volume ratio of getters of the combination of getters may favourably be tuned to allow for a cost-optimization of processes related to maintaining a vacuum quality of a vacuum region of a magnetic resonance device.

Furthermore, the inventive combination of getters may facilitate a handling of getters for magnetic resonance devices, but also a process of inserting or introducing the getters into the vacuum region of the magnetic resonance device.

The inventive magnetic resonance device is configured to acquire magnetic resonance data from an object positioned within an imaging region of the magnetic resonance device.

Preferably, the magnetic resonance device is configured to acquire magnetic resonance image data, particularly diagnostic magnetic resonance image data, from the object positioned within the imaging region. The object may be a patient, particularly a human or an animal.

Preferably, the inventive magnetic resonance device is a closed bore scanner. A closed bore scanner may comprise a substantially cylindrical bore circumferentially enclosing the imaging region.

A main magnet of the closed bore scanner may comprise one or more solenoid coils circumferentially encompassing the imaging region along an axial direction or an axis of rotational symmetry of the cylindrical bore. The one or more solenoid coils may comprise a wire having negligible electrical resistance at (or below) a superconducting temperature. A direction of a main magnetic field provided via the main magnet may be oriented substantially in parallel to a direction of access of the object to the imaging region and/or the axial direction of the cylindrical bore.

According to the invention, the magnetic resonance device comprises a cryostat structure according to an embodiment described above.

The magnetic resonance device may comprise at least one cryocooler. The at least one cryocooler may be configured to cool components of the magnetic resonance device. For example, the at least one cryocooler may be configured to cool the main magnet, the thermal shield, a further thermal shield, a cryogen vessel, a support structure, and the like.

In a preferred embodiment, the at least one cryocooler is thermally and mechanically connected to the main magnet and the thermal shield. The at least one cryocooler may be configured to maintain the main magnet and the thermal shield at different temperature levels. For example, the at least one cryocooler may comprise at least a first cooling stage and a second cooling stage. The first cooling stage may be thermally and mechanically connected to the thermal shield. The second stage may be thermally and mechanically connected to the main magnet. Preferably, a temperature level of the first cooling stage exceeds a temperature level of the second stage. For example, the first cooling stage may be configured to provide a temperature in the range between 30 K to 180 K, preferably in the range between 30 K to 60 K, 60 K to 100 K, or 100 K to 180 K. The second cooling stage may be configured to provide a temperature level close to the superconducting temperature of the main magnet.

The inventive magnetic resonance device may represent a "dry" magnetic resonance device comprising a minimum of cryogen or no cryogen at all. For example, the inventive magnetic resonance device may comprise one or more small cryogen vessels thermally connected to the main magnet via one or more solid thermal conductors. The small cryogen vessels may contain a volume of less than 10 l, less than 5 l, or less than 1 1 of cryogen. In an embodiment of the inventive magnetic resonance device, a cryogen vessel is omitted. Thus, the main magnet may be cooled entirely via thermal conduction.

A cryogen vessel may be configured for storing or preserving a fluid, particularly a cryogen, at a predefined temperature level. Preferably, the fluid or cryogen exhibits a low boiling point, such as Argon, Nitrogen, Neon, Helium, or the like. The predefined temperature level may substantially correspond to a superconducting temperature of the main magnet.

It is conceivable that the components of the magnetic resonance device, such as the main magnet, the thermal shield, the further thermal shield, parts of the support structure, and/or the cryogen vessel, are thermally connected to the at least one cryocooler, preferably via a solid thermal conductor, a convection loop and/or a heat pipe.

In a preferred embodiment, the main magnet is suspended from the outer wall of the outer vacuum chamber via a plurality of suspension rods.

The inventive magnetic resonance device shares the advantages of the inventive cryostat structure and the inventive combination of getters.

Further advantages and details of the present invention may be recognized from the embodiments described below as well as the drawings. The figures show:
Fig. 1 a schematic representation of an embodiment of an inventive magnetic resonance device,
Fig. 2 a schematic representation of an embodiment of an inventive cryostat structure,
Figs. 3 a schematic representation of an aspect of an embodiment of an inventive cryostat structure,
Figs. 4 a schematic representation of an embodiment of an inventive combination of getters,
Figs. 5 a schematic representation of an embodiment of an inventive combination of getters.

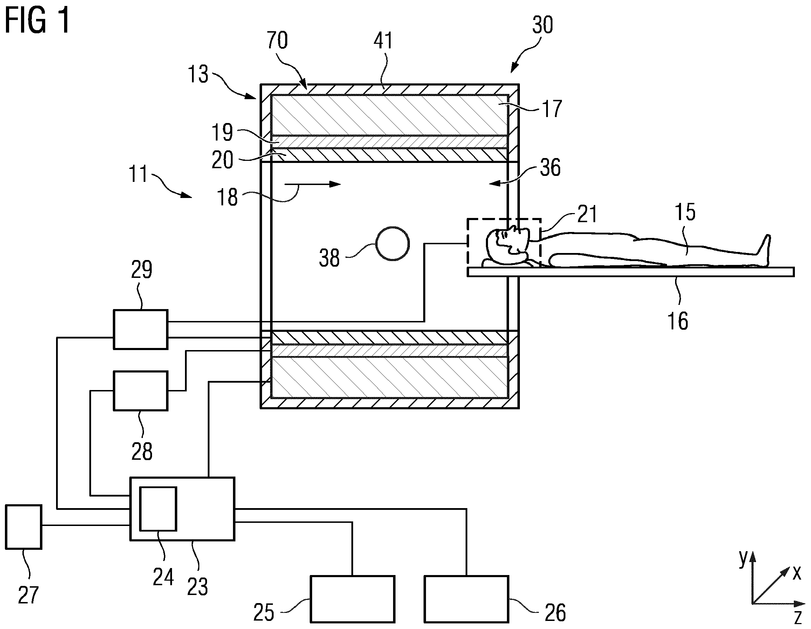

Fig. 1 shows an embodiment of a magnetic resonance device 11 according to the invention. In the illustrated example, the magnetic resonance device 11 comprises a static field magnet 17 (or main magnet) configured to provide a homogenous, static magnetic field 18 (B0 field) comprising an isocentre 38. The static magnetic field 18 permeates a cylindrical imaging region 36 configured for receiving an imaging object, such as a patient 15. The imaging region 36 may substantially correspond to a volume of a patient bore configured for accommodating a patient 15 during a magnetic resonance measurement. The imaging region 36 is encompassed by the field generation unit 30 in a circumferential direction.

In the depicted example, the magnetic resonance device 11 comprises a patient support 16 configured to transport the patient 15 into the imaging region 36. The patient support 16 may be configured to transport a diagnostically relevant body region of the patient 15 into an imaging volume defined by the isocentre 38 of the magnetic resonance device 11. Typically, the field generation unit 30 of the magnetic resonance device 11 is concealed in a housing 41.

The magnetic resonance device 11 may comprise a gradient system 19 configured to provide magnetic gradient fields used for spatial encoding of magnetic resonance signals acquired during a magnetic resonance measurement. The gradient system 19 is activated or controlled by a gradient controller 28 via an appropriate current signal. It is conceivable that the gradient system 19 comprises one or more gradient coils for generating magnetic gradient fields in different, preferably orthogonally oriented, spatial directions.

The magnetic resonance device 11 may comprise an integrated radiofrequency antenna 20 (i. e. a body coil). The radiofrequency antenna 20 is operated via a radiofrequency controller 29 that controls the radiofrequency antenna 20 to generate a high frequency magnetic field and emit radiofrequency excitation pulses into the imaging region 36. The magnetic resonance device 11 may further comprise a local coil 21, which is positioned on or in proximity to the diagnostically relevant region of the patient 15. The local coil 21 may be configured to emit radiofrequency excitation pulses into the patient 15 and/or receive magnetic resonance signals from the patient 15. It is conceivable, that the local coil 21 is controlled via the radiofrequency controller 29.

The magnetic resonance device 11 further comprises a control unit 23 configured for controlling the magnetic resonance device 11. The control unit 23 may comprise a processing unit 24 configured to process magnetic resonance signals and reconstruct magnetic resonance images. The processing unit 24 may also be configured to process input from a user of the magnetic resonance device 11 and/or provide an output to a user. For this purpose, the processing unit 24 and/or the control unit 23 can be connected to a display unit 25 and an input unit 26 via a suitable signal connection. For a preparation of a magnetic resonance measurement, preparatory information, such as imaging parameters or patient information, can be provided to the user via the display unit 25. The input unit 26 may be configured to receive information and/or imaging parameters from the user.

The magnetic resonance device 11 may comprise further components that magnetic resonance devices usually offer. The general operation of a magnetic resonance device 11 is known to those skilled in the art, so a more detailed description is omitted.

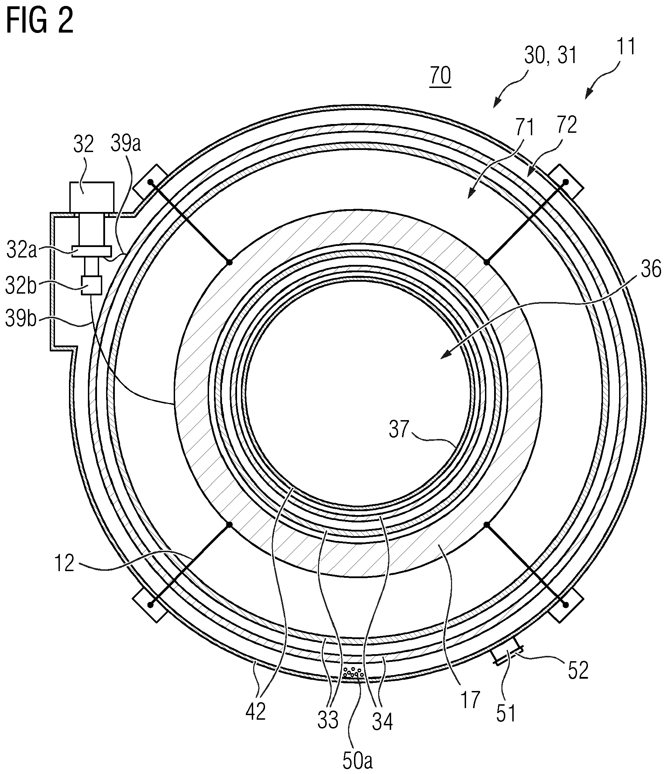

Fig. 2 shows a sectional view of the inventive magnetic resonance device 11 shown in Fig. 1. In the depicted example, the outer vacuum chamber 42 provides an outer enclosure for the components of the field generation unit 30, such as the main magnet 17, an outer thermal shield 34 and an inner thermal shield 33. The outer vacuum chamber 42 separates a surrounding environment 70 from a vacuum region 71 encompassed by the outer vacuum chamber 42.

In a preferred embodiment, the outer vacuum chamber 42 forms a double-walled hollow cylinder comprising an outer wall and an inner wall connected via annular end walls (not shown). The inner wall of the outer vacuum chamber 42 may correspond to a patient bore 37 enclosing the imaging region 36 in a circumferential direction. In the example depicted in Fig. 2, the inner thermal shield 33 and the outer thermal shield 34 are also formed as double-walled hollow cylinders comprising annular end walls (not shown).

The cryostat structure 31 may comprise a plurality of suspension rods 12 mechanically connected to the outer vacuum chamber 42 and the main magnet 17. The suspension rods 12 may extend through passages in the inner thermal shield 33 and the outer thermal shield 34 to provide a mechanical connection between the outer vacuum chamber 42 and the main magnet 17.

The magnetic resonance device 11 further comprises a cryocooler 32 mounted on the outer vacuum chamber 42. The cryocooler 32 may be configured to cool the main magnet 17, the inner thermal shield 33, the outer thermal shield 34, but also other components of the field generation unit 30, such as a cryogen vessel (not shown).

The cryocooler 32 typically comprises a compressor supplying pressurized gas to the cryocooler 32 (not shown). According to the embodiment shown in Fig. 2, the cryocooler 32 includes a cold head comprising one or more cooling stages 32a and 32b. A first cooling stage 32a of the cold head is thermally connected to the outer thermal shield 34, whereas a second cooling stage 32b of the cold head is thermally connected to the main magnet 17. In a preferred embodiment, the first cooling stage 32a provides a temperature level of about 50 K, whereas the second cooling stage 32b provides a temperature level of about 4 K. In "dry" magnetic resonance devices, the cooling stages 32a and 32b of the cryocooler 32 may be mechanically connected to components of the field generation unit 30 via solid thermal conductors 39a and 39b. It is also conceivable that the magnetic resonance device 11 comprises one or more small cryogen vessels (not shown) thermally connected to the cryocooler 32 via a solid thermal conductor, a heat pipe, and/or a convective loop. The one or more cryogen vessels may be thermally connected to the main magnet 17 via a heat exchanger and/or a solid thermal conductor 39.

During operation of the magnetic resonance device 11, the outer thermal shield 34 may be maintained at an intermediate temperature, e. g. between 30 K and 60 K, preferably about 50 K. The outer thermal shield 34 may comprise or consist of an electrically conductive material configured for shielding the main magnet 17 from blackbody radiation emitted in the region 72.

Preferably, a side of the outer thermal shield 34 directed towards the outer vacuum chamber 42 is wrapped in a thermally insulating material, such as MLI (multi-layer insulation). Thus, a region 72 arranged between the outer thermal shield 34 and the outer wall of the outer vacuum chamber 42 may be approximately at an ambient temperature level, even if the region 71 enclosed by the outer thermal shield 34 and the inner thermal shield 33 is maintained at a temperature close to a superconducting temperature of the main magnet 17.

In the example depicted in Fig. 2, the inventive cryostat structure 31 comprises a combination of getters 50a. The combination of getters 50a consists of a mixture of a water getter and a hydrogen getter disposed freely moveable within the region 72 arranged between the outer thermal shield 43 and the outer wall of the outer vacuum chamber 42. Preferably, the water getter and the hydrogen getter are selected from a zeolite, a desiccant, and/or a molecular sieve. It is conceivable that the combination of getters 50a is configured to be poured into the outer vacuum chamber via a small hole in the outer vacuum chamber 42, such as an electrical feed-through.

As illustrated in Fig. 2, the cryostat structure 31 comprises a pump-out port 51 sealed by a plug 52. The pump-out port 51 is configured to connect to a vacuum pump or a conduit connected to a vacuum pump to allow for pumping of the cryostat and establish a vacuum in the regions 71 and 72.

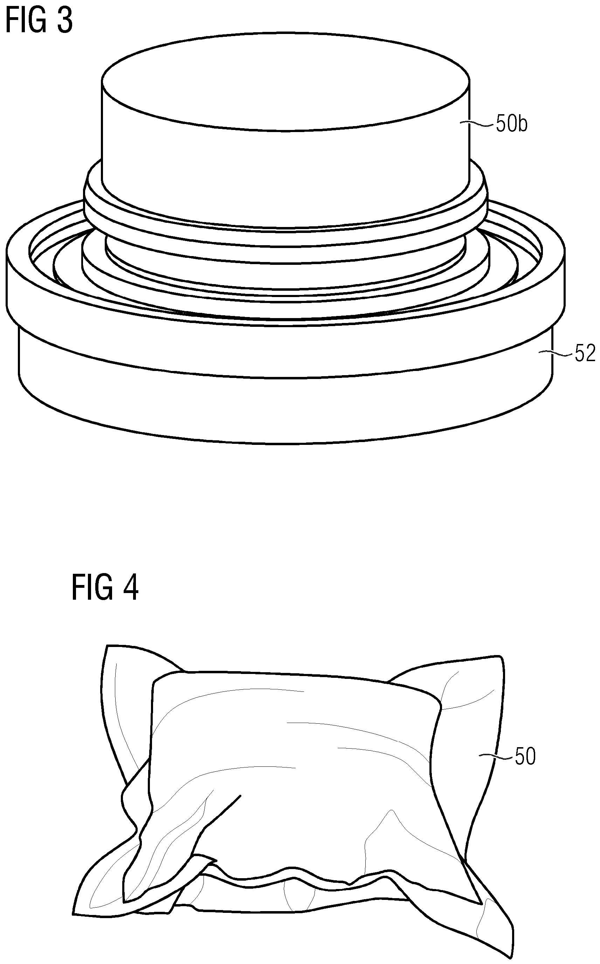

The cryostat structure 31, but also the inventive combination of getters 50, may comprise an air getter 50b as shown in Fig. 3. In the depicted example, the air getter 50b is attached to a plug 52 configured to seal a pump-out port 51 of a cryostat structure 31 as depicted in Fig. 2. The air getter 50b is attached to a side of the plug 52 facing towards the region 72 when the plug is mechanically connected to the pump-out port 51 in an intended position. The air getter 50b may be provided in a gas-permeable casing which can be mounted to the plug 52 in any suitable fashion. In the depicted embodiment, the gas-permeable casing containing the air getter 50b is attached to the plug 52 via an adhesive. However, the air getter 50b may also be clamped, clipped, or strapped onto the plug 52, or held by the plug 52 in any suitable fashion. In mounting the air getter 50b directly onto the plug 52, the air getter 50b may be installed within the region 72 just after a vacuum is established within the cryostat structure 31.

In sealing the pump-out port 51 of the cryostat structure 31 depicted in Fig. 2 via the plug 52 depicted in Fig. 3, the combination of getters 50 may favourably comprise a mixture 50a comprising a water getter and a hydrogen getter, but also an air getter 50b. The combination of getters 50 may comprise or consist of any combination of the getter materials described above.

In a preferred embodiment, the getter 50b depicted in Fig. 3 is a non-activated air getter, whereas the combination of getters 50a shown in Fig. 2 comprises a non-evaporable, non-activated water getter and a non-evaporable, non-activated hydrogen getter.

Fig. 4 shows an embodiment of an inventive combination of getters 50. In the depicted example, the combination of getters 50 is contained within a gas-permeable bag or casing configured to be disposed within a region 72 (see Fig. 2) arranged between the outer wall of the outer vacuum chamber 42 and the thermal shield 34 of a cryostat structure 31.

Preferably, the combination of getters 50 contained within the gas-permeable bag or casing is selected from a zeolite, a molecular sieve, and/or a desiccant. The gas-permeable bag or casing may contain a mixture of a hydrogen getter and a water getter. However, the gas-permeable bag or casing may also comprise an air getter, preferably a non-evaporable, non-activated air getter.

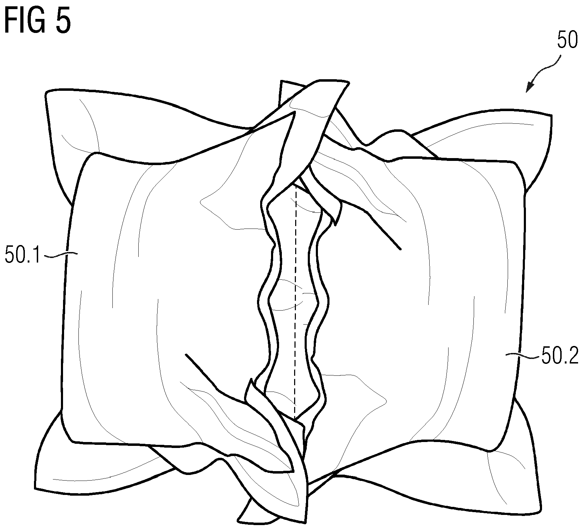

Fig. 5 shows a further embodiment of an inventive combination of getters 50. In the depicted example, the combination of getters 50 comprises a first gas-permeable bag 50.1 containing a water getter and a second gas-permeable bag 50.2 containing a hydrogen getter. Preferably, a weight ratio of the hydrogen getter and the water getter is adapted or optimized to a volume of a cryostat structure 31 and/or an expected composition of residual gasses in a cryostat structure 31 of a magnetic resonance device 11. Particularly, the ratio of the water getter and the hydrogen getter may be tuned in dependence of an expected volume of hydrogen generated via chemical reactions depending on water as an educt. It is conceivable that the combination of getters 50 comprises a further gas-permeable bag 50.3 (not shown). For example, the gas-permeable bag 50.3 may contain an air getter, a further water getter, and/or a further hydrogen getter. The gas-permeable bags 50.1, 50.2, but also 50.3, may be attached to another along a seam or joint (as indicated by the dashed line).

According to an embodiment, the first gas-permeable bag 50.1 may comprise a mixture of a non-activated water getter and a non-activated hydrogen getter according to an embodiment described above. The second gas-permeable bag 50.2 may comprise a non-activated air getter according to an embodiment described above. The first gas-permeable bag 50.1 may be mechanically connected to the second gas-permeable bag 50.2 as shown in Fig. 5. Thus, a process of inserting the combination of getters 50 into the vacuum region of a cryostat structure 31 may favourably be facilitated.

In a preferred embodiment, a weight ratio of the hydrogen getter and the water getter is optimized for a specific cryostat structure 31, particularly a composition of materials within the cryostat structure 31. It is also conceivable that a weight ratio of the air getter and the hydrogen getter and/or the water getter is optimized in a similar fashion.

The first gas-permeable bag 50.1 and the second gas-permeable bag 50.2 may be mechanically connected. However, the first gas-permeable bag 50.1 and the second gas-permeable bag 50.2 may also form separate bags, allowing for installing or disposing the bags 50.1 and 50.2 within a cryostat structure at different times and/or in different positions. It is also conceivable that the gas-permeable bags 50.1 and 50.2, but also 50.3, can be separated manually along the seam indicated by the dashed line.

The embodiments described herein are to be recognized as examples. It is to be understood that individual embodiments may be extended by or combined with features of other embodiments if not stated otherwise. The embodiments depicted in the Figs. 1 to 5 are representations that do not necessarily have to be to scale.

## Claims

1. Cryostat structure (31) for a magnetic resonance device (11), comprising an outer vacuum chamber (42), a thermal shield (34), a main magnet (17), and a combination of getters (50), wherein the combination of getters (50) comprises a hydrogen getter and a water getter.

2. Cryostat structure (31) according to claim 1, wherein at least one getter of the combination of getters (50) is arranged between the outer vacuum chamber (42) and the thermal shield (34).

3. Cryostat structure (31) according to claim 1 or claim 2, wherein the combination of getters (50) comprises an air getter.

4. Cryostat structure (31) according to claim 3, wherein the air getter consists of a non-evaporable getter.

5. Cryostat structure (31) according to claim 3, wherein the air getter consists of a flashed getter.

6. Cryostat structure (31) according to one of the claims 3 to 5, comprising a pump-out port (51) and a plug (52) configured to provide a fluid-tight seal on the pump-out port (51), wherein the air getter is mounted to a side of the plug (52) facing towards an inner volume of the cryostat structure (31).

7. Cryostat structure (31) according to one of the preceding claims, wherein the water getter consists of a non-evaporable getter.

8. Cryostat structure (31) according to one of the preceding claims, wherein the hydrogen getter consists of a non-evaporable getter.

9. Cryostat structure (31) according to one of the preceding claims, wherein the water getter consists of a zeolite, a molecular sieve, or a desiccant, and wherein the hydrogen getter consists of a zeolite, particularly a silver-exchanged zeolite.

10. Cryostat structure (31) according to one of the preceding claims, wherein the hydrogen getter and the water getter each consist of a non-evaporable, non-activated getter.

11. Cryostat structure (31) according to one of the preceding claims, wherein the water getter and/or the hydrogen getter comprise a loose material, or a loose material enclosed in a gas-permeable casing.

12. Cryostat structure (31) according to one of the preceding claims 9 or 10, wherein the water getter and/or the hydrogen getter comprise a loose material and wherein the loose material is disposed freely moveable within a volume encompassed by the outer vacuum chamber (42).

13. Cryostat structure (31) according to one of the claims 1 to 7, wherein the hydrogen getter consists of a flashed getter.

14. Combination of getters (50) for use in a cryostat structure (31) according to one of the preceding claims, comprising a water getter and a hydrogen getter.

15. Combination of getters (50) according to claim 14, further comprising an air getter.

16. Magnetic resonance device (11), configured to acquire magnetic resonance data from an object positioned within an imaging region (36) of the magnetic resonance device (11), comprising a cryostat structure (31) according to one of the claims 1 to 13.
